# FASCICULE DE BREVET EUROPEEN

(11) **EP 2 148 366 B1**
(45) Date de publication et mention de la délivrance du brevet: **01.05.2019**
(21) Numéro de dépôt: 09165564.7
(22) Date de dépôt: 15.07.2009
(51) Int. Cl.: H01L 23/538, H01L 21/68, H01L 23/31, H01L 23/00, H01L 21/683

(54) **Dispositif multi composants intégrés dans une matrice**
Bauelement mit einer Vielzahl an integrierten Bauelementen in einer Matrix
Device having plurality of integrated circuits in a matrix

(30) Priorité: 21.07.2008 FR 0854944
(43) Date de publication de la demande: 27.01.2010
(73) Titulaire: Commissariat à l'Énergie Atomique et aux Énergies Alternatives, 75015 Paris (FR)
(72) Inventeur: Souriau, Jean-Charles, 38120 Saint-Egreve (FR)
(74) Mandataire: Ilgart, Jean-Christophe

(56) Documents cités:
- DE-C1- 19 907 295
- US-A- 5 353 195
- US-A- 6 154 366
- US-A1- 2006 051 895
- US-A1- 2006 220 222
- US-A1- 2007 080 458
- US-A1- 2007 108 610
- US-A1- 2008 142 946
- US-B2- 6 998 533

## Description

### DOMAINE TECHNIQUE ET ART ANTERIEUR

L'invention concerne le domaine de l'assemblage de microsystèmes ou de nanosystèmes à l'échelle d'une plaquette, par exemple en matériau semi-conducteur, tel que du silicium.

Elle concerne notamment les applications pour lesquelles sont recherchées des technologies d'intégration à haute densité de composants passifs, de détecteurs ou composants optoélectroniques ou de MEMS ou de NEMS directement sur les circuits, communément appelées "Above IC".

Actuellement, les procédés d'intégration hétérogène ne peuvent se faire que sur des plaquettes de silicium entières. Les procédés " Above IC " sont donc limités aux domaines où l'intégrateur du microsystème peut disposer de plaquettes, ce qui implique des coûts importants en termes de jeu de masques et de fabrication des plaquettes chez un fondeur.

De plus, pour les applications comme la téléphonie, la surface active des circuits intégrés n'est pas suffisante pour y accueillir tous les éléments nécessaires au système (composant passifs, amplificateurs, switch, composants SAW ou BAW), ce qui est en particulier dû au fait que le rendement diminue quand la complexité des puces augmente. Il est donc nécessaire d'assembler post fabrication les différents éléments sur des substrats de type PCB (circuit imprimé) ou céramique. Les architectures sont souvent complexes et l'assemblage et l'interconnexion nécessitent beaucoup d'opérations individuelles (placement des composants et câblage filaire).

Il existe une autre technique permettant l'intégration de nombreuses fonctionnalités sur une même puce, tout en ayant de bons rendements. Dans cette technique on reconstitue une plaquette à partir de puces discrètes disposés sur une plaquette support puis en les scellant avec un matériau d'enrobage et en éliminant la plaquette support. Cette plaquette reconstituée permet de procéder à des intégrations de type « above IC », mélangeant des composants provenant de plusieurs sources et assemblés dans un format adapté aux outils de dépôt disponible pour l'industriel. De plus, cette technique permet de réaliser des dispositifs complexes, contenant des composants fabriqués sur des substrats différents, en ne choisissant que des composants fonctionnels.

Cette technique, dans laquelle on colle temporairement les faces actives des composants sur un adhésif, puis on les enrobe et on réalise un reroutage par-dessus, a été publiée en 1992 par Chang-Lee Chen et al. Dans un article intitulé « Bond Wireless Multipchip packaging Technology for High Speed Circuits », paru dans "IEEE Transactions On component Hybrids and Manufacturing Technology, Vol. 15 N° 4, pages 451-456."

On connaît également, dans ce type de technique, les procédés décrits dans les documents US 5 353 498 et US 5 497 033, ainsi que la technique décrite dans le document FR 2 857 157. La technique décrite dans le document FR 2 864 342 s'applique à des composants déjà dans un boîtier ; elle est très complexe car il faut alors meuler une partie du boîtier pour reprendre les contacts des composants.

Enfin, selon une autre méthode, décrite dans le document GB 2 202 673 et représentée schématiquement dans les figures 8A-8C, les puces discrètes sont disposées dans des cavités **107** présentes dans une plaquette d'accueil puis scellées avec un matériau d'enrobage de façon à former une plaquette reconstituée contenant les composants. La technique ainsi présentée utilise de façon nécessaire à son déroulement un substrat support 121 sur lequel est présent un film adhésif 122. La couche adhésive permet de maintenir la plaquette de portage puis les puces actives sur le substrat support durant les étapes de procédé pendant lesquelles le matériau de remplissage n'est pas encore déposé et ne peut donc assurer la tenue mécanique des éléments de la plaquette reconstituée.

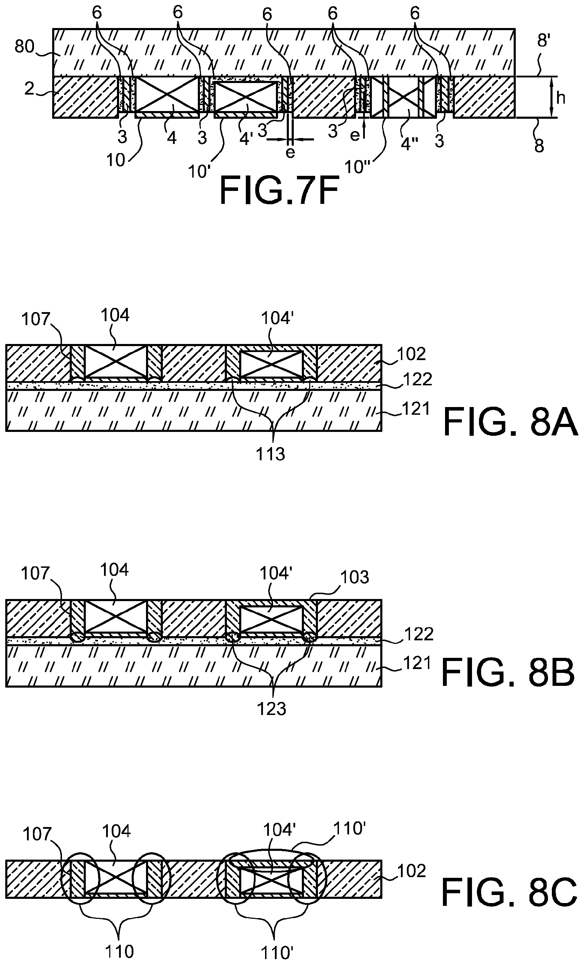

Cette couche d'enrobage peut présenter trois types de défauts illustrés dans les figures 8A-8C.

Tout d'abord, lors du dépôt du matériau d'enrobage, le matériau peut ne pas adhérer à la couche d'adhérence (figure 8A) ; au contraire, il peut interagir de façon trop importante avec la couche d'adhérence et il peut donc y avoir miscibilité (figure 8B). On a donc, suivant le cas, soit une ou des zone(s) de rétreint 113 (figure 8A) soit des zones 123 de mélange du matériau 103 et de d'adhésif 122 (figure 8B). Lors du retrait de la couche adhérente, ces cas de miscibilité ou de démouillage peuvent conduire à des arrachements du matériau d'enrobage, ou des composants, à l'apparition de contraintes importantes sur la plaquette ou à la mauvaise tenue des composants.

Des coefficients d'expansion thermique (CTE) différents entre, d'une part, la couche d'enrobage 103 (CTE proche de 10ppm/°C ou supérieur à cette valeur) et, d'autre part, les substrats de la plaquette d'accueil 102 et/ou des composants 104 (CTE voisin de 2,3 ppm/°C pour du silicium) induisent l'apparition de contraintes fortes dans la couche d'enrobage (figure 8C) lors de variations de température, par exemple lors du durcissement de la couche d'enrobage. Ces contraintes induisent une déformation de la plaquette et même des ruptures. Elles sont identifiées sur la figure 8C par les zones 110, 110' et se situent soit sur le pourtour des composants 104, soit sur leur face arrière.

L'invention vise à résoudre ces problèmes. Elle vise notamment à réduire l'impact de la différence de CTE sur les contraintes dans la plaquette.

Un autre but de l'invention est d'améliorer l'interface entre le dispositif en cours de fabrication et la couche d'adhérence.

Le document US 2007/080458 décrit un module hybride et un procédé pour le réaliser.

Le docuent US 2006/0220222 divulgue une structure de puce intégrée et son procédé de réalisation.

Le document US 6 998 533 décrit un dispositif électronique comportant un élément semiconducteur dans une cavité avec une couche thermiquement isolante.

### EXPOSÉ DE L'INVENTION

L'invention concerne tout d'abord une plaquette électronique, telle que décrite dans la revendication 1, ayant une face avant et une face arrière, muni d'au moins un composant discret intégré, la face active du composant apparaissant du coté de la face avant et comportant :
- un matériau d'enrobage, présent au moins latéralement par rapport au composant, assurant le maintient du dit composant dans le dispositif,
- une couche tampon, absente de la face active du composant, séparant le matériau d'enrobage du ou des composant(s).

Dans le cas de deux composants voisins, la couche tampon ne remplit pas entièrement l'espace entre les composants, l'espace restant, entre les composants ou entre des portions de couche tampon présentes sur les flancs des composants, étant occupé par le matériau d'enrobage.

Dans un mode de réalisation, le ou les composant(s) est (sont) placé(s) dans au moins une cavité présente dans une matrice d'accueil, la ou les cavités traversant la matrice d'accueil, la couche tampon étant au moins présente sur les flancs de la ou des cavités. La couche tampon sépare ainsi le matériau d'enrobage du ou des composant(s) et de la matrice d'accueil, et est absente de la face avant de la matrice d'accueil. Elle ne remplit pas entièrement l'espace entre les flancs de la ou des cavités et les flancs des composants.

Quel que soit le mode de réalisation, la couche tampon a des propriétés lui permettant de limiter ou d'absorber les contraintes qui peuvent apparaître entre, d'une part, le matériau d'enrobage et, d'autre part, le ou les composants et l'éventuelle plaquette, lors de montées et/ou de descentes en températures.

Selon deux variantes de chacun des dispositifs précédents :
- la couche tampon peut masquer le matériau d'enrobage sur la face avant du dispositif ;
- le matériau d'enrobage peut être apparent sur la face avant du dispositif, la couche tampon n'étant présente que sur les flancs du composant, le matériau d'enrobage et la couche tampon présentant un retrait par rapport à la surface active des composants.

L'invention concerne également un procédé d'intégration d'au moins un composant discret intégré en une plaquette, tel que décrit dans la revendication 9, dite plaquette reconstituée, procédé dans lequel :
a) on positionne au moins un composant discret sur un substrat, dit substrat support,
b) puis on dépose une couche tampon au moins sur la face arrière et les flancs du composant, ladite couche tampon ne se déposant pas sur les surfaces en contact avec le substrat.
c) ensuite on dépose un matériau d'enrobage au moins latéralement par rapport au composant, ce matériau étant déposé uniquement sur des surfaces recouvertes par la couche tampon.

L'étape a) peut comporter le positionnement de un ou plusieurs composants dans une ou plusieurs cavités traversant une matrice d'accueil.

La formation de la couche tampon lors de l'étape b) est réalisée au moins sur la face arrière de la matrice et les flancs de la ou des cavités, ladite couche tampon ne remplissant pas entièrement l'espace entre le flanc des cavités et le flanc des composants, et séparant, à l'issue de l'étape c), le matériau d'enrobage du matériau de la matrice d'accueil.

La matrice peut être positionnée en premier sur le substrat support, puis les composants sont positionnés dans la ou les cavités de la matrice d'accueil. Inversement, la matrice peut n'être placée qu'une fois les composants discrets positionnés, la ou les cavités entourant les composants.

Le substrat support peut être en silicium, ou en verre, ou en alumine, ou en quartz ou en polymère.

Un procédé selon l'invention peut comporter en outre une étape d'amincissement de la face arrière de la plaquette.

Un procédé selon l'invention peut comporter en outre une étape de collage en face arrière d'un substrat de renfort servant à assurer la tenue mécanique.

Dans un procédé selon l'invention, une couche adhérente peut être déposée sur le substrat support préalablement à l'étape a), la couche tampon déposée en b) étant déposée sur au moins une partie du matériau adhérent non occupé par un composant, la face arrière et les flancs du ou des composant(s) et éventuellement sur le dos de la matrice d'accueil et les flancs des cavités.

Dans un procédé selon l'invention la couche tampon adhère avantageusement à la couche d'adhérence et à la face arrière et aux flancs du ou des composant(s) et est préférentiellement non-miscible avec la couche adhérente. Ainsi, la couche tampon permet d'éviter la formation de matériau de réaction à la surface de la couche adhérente tout en maintenant les différents éléments sur le substrat support.

De plus, pour réduire les effets des contraintes la couche tampon, par exemple apparaissant dans la plaquette reconstituée lors de procédés d'intégration above IC ou lors du durcissement du matériau d'enrobage, a une température de transition vitreuse inférieure à celle du matériau d'enrobage. Elle se déforme alors sous l'influence de contraintes en compression. Pour assurer sa déformation lors des variations négatives de températures, la couche tampon a aussi de préférence un module d'Young faible.

Dans un procédé selon l'invention, la couche tampon peut être déposée en phase gazeuse, ou par ALD, ou par CVD, ou par procédé sol-gel.

Dans un procédé ou un dispositif selon l'invention, le ou les composant(s) a/ont un substrat par exemple principalement en silicium, ou en AsGa, ou en InP ou en verre. De plus, chaque composant peut être de dimensions et de type différents des dimensions ou type d'autres composants intégrés dans la même plaquette.

Chaque composant est par exemple du type composant électronique, ou MEMS ou NEMS, ou MOEMS ou NOEMS, ou bio-composant, ou composant passif ou composant servant au passage conducteur entre les faces avant et arrière du dispositif ou servant uniquement au passage conducteur entre les faces avant et arrière du dispositif.

La couche tampon a avantageusement une épaisseur comprise entre 10 nm et 10 µm.

La couche tampon peut être en PMDA-DAH ou en PMDA EAD ou en PMDA ODA ou en PMDA DNB, ou en poly-V3D3, ou en une résine minérale organique ou en parylène C ou en parylène N ou en parylène D.

Dans un procédé ou un dispositif selon l'invention, le matériau d'enrobage peut être de type époxy ou polyuréthane ou élastomère ou silicone ou acrylique ou méthacrylate ou polypropylène ou verre fusible ou de type verre fusible mélangé avec des particules de silice.

Dans un procédé ou un dispositif selon l'invention, dans le cas où il y a une matrice d'accueil avec des cavités, la matrice d'accueil peut être en silicium ou en AsGA ou en InP ou en verre. De plus, la surface de cette plaquette ou matrice d'accueil peut comporter un ou plusieurs composants semi-conducteurs parmi des composants électroniques, des MEMS ou des NEMS, des MOEMS ou des NOEMS, ou des bio-composants, ou des composants passifs.

### BRÈVE DESCRIPTION DES DESSINS

- Les figures 1, 2 et 3 représentent des exemples de dispositifs selon l'invention,
- la figure 4 représente un des dispositifs selon l'invention sous la forme d'une plaquette reconstituée,
- les figures 5A - 5F sont des étapes d'un exemple de mise en oeuvre d'un procédé selon l'invention,
- la figure 6 est un tableau reprenant les propriétés de matériaux proposés comme couche tampon dans le cadre de l'invention,
- les figures 7A-7F sont des étapes d'un exemple de mise en oeuvre d'un deuxième procédé selon l'invention,
- les figures 8A-8C illustrent les problèmes identifiés par les inventeurs,
- la figure 9 illustre un exemple d'application d'un dispositif réalisé selon l'invention après passage dans une ligne de traitement above-IC.

### EXPOSÉ DÉTAILLÉ DE MODES DE RÉALISATION DE L'INVENTION

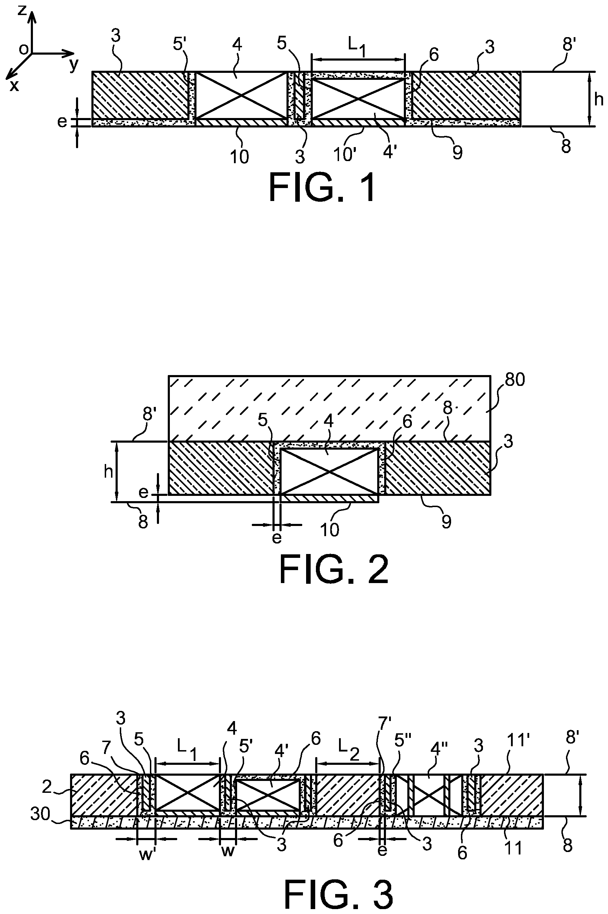

Des modes de réalisation de l'invention sont détaillés ci-dessous, illustrés par les figures 1 à 7 dans lesquelles les références des différents éléments sont communes aux différentes figures.

Un premier dispositif selon l'invention est représenté en coupe sur la figure 1.

Ce dispositif comporte un ou plusieurs composants électroniques 4 et 4' d'épaisseur maximale h et de largeur L1. Les faces actives des composants sont désignées par les références 10 et 10': il s'agit des faces sur lesquelles sont réalisés les composants élémentaires définissant les fonctionnalités des composants. Les faces 10 et 10' affleurent la face 8, dite face avant du dispositif. Le dispositif suivant ce mode, mais également suivant les autres modes de réalisation, s'étend sensiblement dans un plan xy, son épaisseur h suivant la direction z, perpendiculaire au plan xOy étant petite par rapport à ses directions d'extension dans ce même plan xOy, l'épaisseur h pouvant aller de 10 µm ou de 300 µm à quelques millimètres, par exemple 1 mm ou 5 mm, les dimensions du dispositif dans le plan xOy pouvant aller de 150 mm à 400 mm ou même plus, notamment pour une dalle de verre.

Le dispositif comporte de plus une couche tampon **6,** présente au moins sur les flancs 5 et 5' des composants ainsi que sur la face 8 du dispositif. Dans cet exemple mais aussi dans les exemples qui suivent, on appelle flancs des composants des parties de ces composants qui sont sensiblement perpendiculaires au plan xOy du dispositif. Cette couche tampon est d'épaisseur e. Dans le cas où il y a plus de un composant, l'épaisseur e est choisie de telle sorte qu'elle ne remplisse pas intégralement l'espace situé entre deux composants. Avantageusement, e est plus petit que 0,1 fois w, largeur de cet espace.

Enfin, un matériau d'enrobage 3, différent du matériau de la couche tampon, est présent, séparé des composants 4 et 4' et de la face 8 du dispositif par la couche tampon 6. Donc, entre deux composants, suivant un axe parallèle au plan de la surface 8 ou au plan xOy, hormis peut être pour une épaisseur e proche de la surface 8, deux composants sont séparés par au moins une première portion de couche tampon, une couche de matériau d'enrobage et une deuxième portion de couche tampon.

Un ou plusieurs des composants 4 peut/peuvent être choisis parmi divers types de composants microélectroniques, par exemple chacun peut être un circuit intégré, et/ou un capteur MEMS ou NEMS, et/ou un composant optique (MOEMS ou NOEMS) et/ou un biocomposant et/ou un commutateur, et/ou un composant servant uniquement de passage conducteur entre les deux faces du dispositif. Ces composants peuvent être tous identiques ou être différents entre eux (ils peuvent notamment avoir des épaisseurs différentes les unes des autres).

La face 8 peut ensuite être traitée par des procédés de type microélectronique ou « above-IC », comme expliqué ci-dessous.

La couche tampon 6 a des propriétés lui permettant de limiter ou d'absorber les contraintes qui peuvent apparaître entre, d'une part, matériau d'enrobage et, d'autre part, le ou les composants et l'éventuelle plaquette, lors de montées et/ou de descentes en températures.

Ainsi, cette couche tampon a, de préférence, un module d'Young bas, inférieur à celui de la résine d'enrobage. Ce module d'Young de la couche tampon est avantageusement compris entre 1,5 GPa et 10 GPa.

La couche tampon a une température de transition vitreuse Tg(6) inférieure à celle du matériau d'enrobage 3 Tg(3), par exemple comprise entre 80°C et 150°C (c'est le cas du parylène), les matériaux d'enrobage 3 - et notamment ceux donnés ici en exemple - ayant généralement une température de transition vitreuse comprise entre 120°C et 220°C.

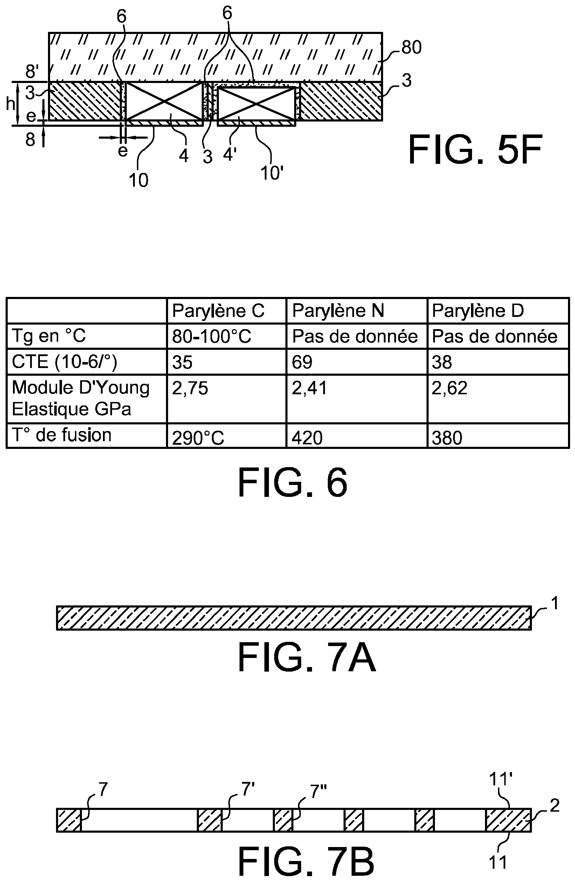

A titre d'exemple, la couche tampon peut être en PMDA-DAH ou en PMDA EDA ou en PMDA ODA ou en PMDA-DNB ou en PMDA-PDA, ou en poly-V3D3 (il s'agit du poly(1,3,5-trivinyltrimethylcyclotrisiloxane)) ou en une résine minérale organique ou en parylène C ou en parylène N ou en parylène D. Avantageusement, la couche tampon 6 est en parylène C ou en parylène N ou en parylène D dont les propriétés sont données dans le tableau de la figure 6. On rappelle que le PMDA est le 1,2,3,5-benzenetétracarboxylic anhydride, le DNB est le 2,4-diaminonitrobenzène, le ODA est le 4,4 - oxydianiline et le EDA est l'ethylènediamine, le DAH est le 1,6-diaminohéxane, le PDA est le 1,4-phenylenediamine.

Le matériau d'enrobage 3 a avantageusement un coefficient d'expansion thermique (CTE) bas, c'est - à - dire par exemple compris entre 5 ppm/°C et 50 ppm/°C, plus particulièrement inférieure à 20 ppm/°C.

A titre d'exemple de matériau d'enrobage 3, on peut citer la résine époxy, le polyuréthane, l'élastomère, les matériaux silicones, l'acrylique, les méthacrylates, le polypropylène, ou un verre fusible. Pour diminuer le CTE de chacun de ces matériaux, il peut être choisi de les mélanger avec des particules, par exemple en silice, ou d'un autre type de matériau dans le but de conférer au matériau d'enrobage ainsi formé des propriétés électriques et/ou thermiques et/ou mécaniques.

La figure 2 représente un cas particulier du premier mode de réalisation de l'invention où le dispositif ne comporte qu'un seul composant 4, qui n'a pas de composants voisins. Dans ce cas particulier, la couche tampon affleurant la surface 8 a, de plus, été retirée, mettant à jour la surface 9 du matériau 3, une marche d'épaisseur e étant alors présente entre la surface 10 et la surface 9. Ce dispositif comporte en outre un substrat 80 de renfort collé sur la face arrière du dispositif.

La figure 3 illustre un troisième mode de réalisation de l'invention où les différents composants discrets 4, 4' et 4" sont disposés dans une ou plusieurs cavités 7 et 7' réalisées à l'intérieur d'une matrice 2, d'épaisseur h. On note qu'il est possible d'avoir plusieurs composants dans une même cavité (c'est le cas des deux composants 4, 4' de la figure 3). La face avant 11 de la matrice 2 affleure la face 8 du dispositif, et est donc approximativement au même niveau que les faces 10, 10' et 10" des composants 4. De préférence, la matrice d'accueil est en un matériau dont le CTE est identique ou proche de celui des composants discrets. Elle est par exemple en un matériau semi-conducteur, tel que du silicium.

Dans la matrice 2, deux cavités 7, 7' voisines peuvent être séparées par une distance désignée par L₂, L₁ désignant quant à elle la largeur d'un composant. Des ordres de grandeur pour les dimensions de h, L₁ et L₂ sont donnés plus loin.

Dans le mode de réalisation de la figure 3, les flancs des cavités 7 sont recouvert par la couche tampon 6 dont l'épaisseur e est choisie de telle sorte qu'elle ne remplisse pas intégralement les espaces entre deux composants et les intervalles entre les bords des cavités 7 et les bords 5, 5' ou 5" des composants. Avantageusement, e est plus petit que 0,1 fois w et w', largeurs respectives de ces intervalles.

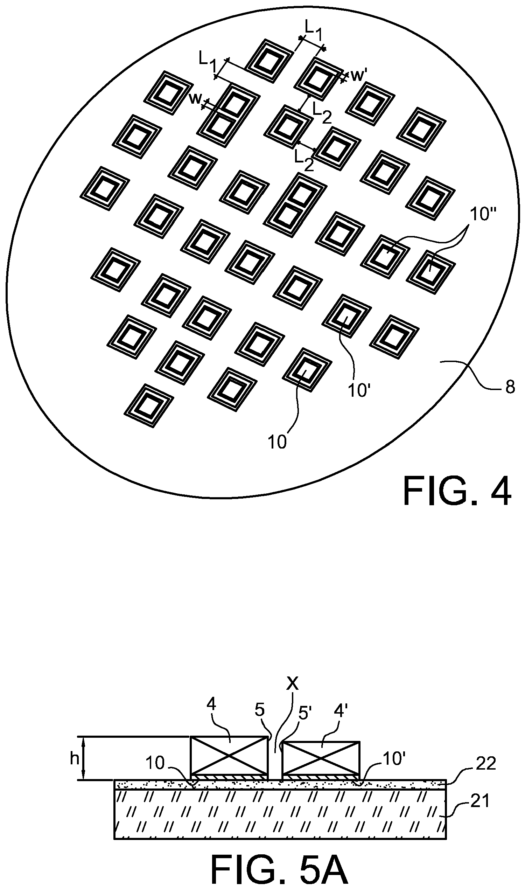

La figure 4 représente un dispositif intégré selon l'invention, du type de la figure 3. Ce dispositif comporte donc un substrat constitué de la matrice d'accueil **2.** Dans cette matrice sont insérés une pluralité de composants 4, 4', 4" dont les surfaces actives 10, 10', 10" sont visibles, dans le plan d'une face 8 du dispositif. Les différents composants peuvent avoir des épaisseurs différentes, et en particulier différentes de celle de la matrice 2. La face 11 de la matrice 2 peut avoir été traitée (processée), avant formation des cavités **7.** La plaquette reconstituée de la figure 4 peut ensuite, après application du procédé de l'invention, être traitée par des procédés de type « above IC », comme expliqué ci-dessous.

Des exemples de matériaux pour la couche tampon et la couche d'enrobage du mode de réalisation des figures 3 et 4 sont ceux déjà donnés ci-dessus en liaison avec les figures 1 et 2.

Pour tous les exemples décrits ci-dessus, des ordres de grandeur pour les dimensions h, w, e, L₁ et L₂ peuvent être les suivants :
- h peut être compris entre 10 µm et quelques mm, il est par exemple de l'ordre de 5 mm,
- w et w' peuvent être compris entre 100 µm et quelques mm, ces valeurs sont par exemple de l'ordre de 1 mm,
- e peut être compris entre 10 nm et quelques µm, il est par exemple de l'ordre de 10 µm,
- L₁ peut être compris entre 100 µm et quelques mm, par exemple de l'ordre de 2 cm,
- L₂ peut être compris entre 100 µm et quelques mm, est par exemple de l'ordre de 2 cm,

Ces valeurs sont des exemples et d'autres valeurs sont possibles en dehors des plages indiquées.

Les dispositifs décrits en liaison avec les figures 1, 2 et 3, avec les composants 4, le matériau d'enrobage 3, et la couche tampon 6 peuvent, après avoir été réalisés, être l'objet de divers traitements ou procédés. On peut ainsi citer par exemples les procédés de type «Above IC». Ces procédés de type « Above-IC » susceptibles d'être réalisés sur la face **8** du dispositif et sur les faces actives 10 des composants, et éventuellement sur la face 11 de la matrice 2, peuvent être du type :
- intégration de composants passifs en couche mince (résistances et/ou capacités et/ou inductances),
- et/ou reroutage de contacts électriques et/ou formation d'un ensemble complexe de pistes et de contacts entre les composants 4, 4' et 4". Cet ensemble peut être composé d'empilements des matériaux métalliques et isolants, de façon à former par exemple des interconnexions (couche 30 de la figure 3),
- et/ou intégration, sur la surface 10 des composants 4, de composants optiques (par exemple de micro-lentilles) ou de plots d'interconnexion, par exemple par croissance de billes fusibles, ou transfert de billes, ou fabrication de "Stud Bump", ou croissance de micro-inserts, ou hybridation de composants sur la plaquette (Chip on Wafer).

Ces mêmes traitements peuvent être effectués sur tout dispositif, comportant au moins un composant 4, une couche tampon 6 et un matériau d'enrobage 3, obtenu en combinant tout ou partie des 3 modes de réalisation décrits précédemment.

Un exemple de procédé selon l'invention va être donné, en liaison avec les figures 5A-5F. Cet exemple de procédé permet notamment d'obtenir les dispositifs des figures 1 et 2.

On procède au placement du ou des composants 4 et 4' sur un support 21 rigide et plan, qui est par exemple un substrat support en silicium, ou en verre, ou un masque en quartz ou une plaque d'alumine ou en polymère (figure 5A). Avantageusement, ce substrat a un CTE proche ou même identique à celui des composants 4 afin d'assurer un bon positionnement des composants (limitant ainsi les déplacements et/ou les contraintes au moment du durcissement du matériau d'enrobage 3 (réalisé par exemple par chauffage autour de 200°C)).

Les équipements de placement du ou des composants 4 permettent d'atteindre une précision latérale micronique, avec un parallélisme meilleur que 5.10⁻⁴ rad. Ces valeurs sont suffisantes pour reprendre, lors de l'intégration ultérieure sur la face 8, des contacts sur les plots de connexion des composants situés sur la face active et qui ont généralement une largeur de l'ordre de quelques dizaines de µm.

La tenue temporaire du ou des composants sur le support 21 se fera de préférence grâce à une couche adhérente 22 déposée sur le support (figure 5A). Cette couche 22 est de préférence apte à supporter le traitement thermique ultérieur de durcissement de la résine 3. Elle pourra être retirée par la suite. Ce peut être par exemple une résine déposée à la tournette, ou un film adhésif laminé, ou un polymère photosensible, ou un spray ...

On positionne alors les composants avec leur face active 10 tournée vers le support 21 ou vers l'éventuelle couche d'adhérence 22 formée sur le support 21. L'alignement peut être réalisé grâce à des mires qui auront été réalisées au préalable sur le substrat support 21 ou sur la couche adhérente 22. Il y aura ainsi un espace X entre deux composants.

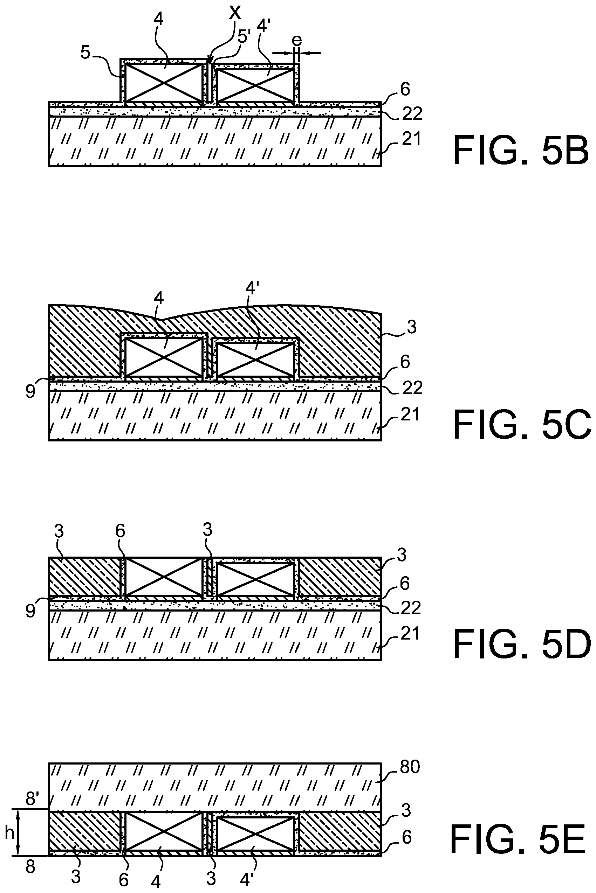

Une épaisseur e de couche tampon 6 est ensuite déposée avec une grande conformité (figure 5B). Cette couche tampon 6 recouvre la face arrière et les cotés 5 du ou des composants 4, 4', ainsi que le substrat 21 (ou l'éventuelle couche adhérente 22).

Cette couche 6 est de préférence choisie pour ses qualités de mouillabilité et d'inertie chimique avec le matériau du substrat 21(et/ou l'éventuelle couche adhérente 22).

Avantageusement, pour absorber les contraintes en tension et se déformer facilement lorsque la température diminue, la couche tampon a un module d'Young bas avantageusement compris entre 1,5 GPa et 10 GPa. A l'inverse, pour absorber les contraintes en compression lors des recuits, cette couche tampon a de préférence, une température de transition vitreuse Tg(6) inférieure à la température de transition vitreuse Tg(3) du matériau d'enrobage 3. Tg(6) est par exemple comprise entre 80°C et 150°C, les matériaux d'enrobage 3 ayant généralement une température de transition vitreuse comprise entre 120°C et 220°C.

L'épaisseur e de cette couche tampon 6 est choisie de telle sorte qu'elle ne remplisse pas intégralement les espaces X entre deux composants. Elle est par exemple choisie inférieure à 0,1 fois w, w désignant la largeur de l'espace X.

Cette couche tampon 6 peut être déposée par ALD, par CVD, par procédé sol-gel ou en phase gazeuse, procédés qui sont adaptés aux épaisseurs recherchées. Avantageusement, la couche tampon 6 est en parylène C ou en parylène N ou en parylène D dont les propriétés sont données dans le tableau de la figure 6.

On procède ensuite au remplissage, par le matériau 3 d'enrobage, de l'espace libre présent entre les composants 4, recouverts de la couche tampon 6 (figure 5C). Le matériau 3 est séparé du ou des composants, du substrat support et de l'éventuelle couche adhérente par au moins la couche tampon 6. Ce matériau 3 est par exemple dispensé localement à la seringue ou bien, de façon plus grossière, en déposant une ou des grosses gouttes dans un moule ou grâce à un dépôt à la tournette. La pénétration de matériau d'enrobage entre deux composants pourra ensuite être facilitée par une mise sous vide. Ce matériau d'enrobage 3 est ensuite durci (par exemple par chauffage).

Un amincissement et un polissage de la face arrière 8' peuvent être ensuite réalisés (figure 5D). Pour certains composants 4, ou pour l'ensemble des composants 4, cet amincissement peut faire disparaître la couche tampon présente en face arrière des composants 4. De plus, cet amincissement du dispositif peut conduire à la réduction de l'épaisseur d'une partie ou de l'ensemble des composants.

Le dispositif peut être ensuite décollé du support 21 et de l'éventuelle couche d'adhérence 22 (figure 5E). Ceux-ci sont retirés, selon leur nature, par pelage, par gravure chimique ou par insolation de la couche d'adhérence 22 à travers le support 21 si ce dernier est transparent. Dans certains cas, le support sera maintenu, notamment si le substrat 21 (et l'éventuelle couche adhérente 22) est transparent à certaines longueurs d'onde et si un ou plusieurs des composants 4 est un composant optique.

Il peut être envisagé, avant ou après l'étape de retrait du support 21, de coller la face arrière du dispositif sur un support de renfort 80 afin de rigidifier l'ensemble (figure 5E).

Il est ensuite possible de procéder sur la face avant 8 à un retrait d'une épaisseur e de la couche tampon 6, (figure 5F), mettant ainsi à jour le matériau d'enrobage 3, en particulier dans les zones qui séparent les composants 4. Mais le matériau de la couche tampon est toujours présent de façon à permettre une séparation entre le matériau d'enrobage 3 et les flancs des composants 4 ; le matériau 3 et la couche tampon 6 présentent alors une marche d'épaisseur e par rapport aux faces 10 du ou des composants 4.

Ensuite le dispositif peut être introduit dans une ligne de type microélectronique pour les étapes «Above IC», par exemple du type déjà décrit ci-dessus.

Un procédé selon un second mode de réalisation de l'invention est présenté en liaison avec les figures 7A-7F. Ce procédé permet entre autres de réaliser le dispositif de la figure 3.

On sélectionne (figure 7A) une plaquette 1, en un matériau ayant un CTE proche des CTE du ou des composants. Par exemple elle est en AsGa ou en silicium vierge ou elle est déjà traitée. Cette plaquette peut comporter, entre autres, des mires de positionnement et/ou des composants (par exemple en couche mince) et/ou des vias conducteurs qui traversent la plaquette.

On réalise dans cette plaquette (figure 7B) des cavités **7,** par une technique telle que la gravure laser, la gravure chimique ou l'usinage ultrason. On a ainsi formé la matrice d'accueil **2.**

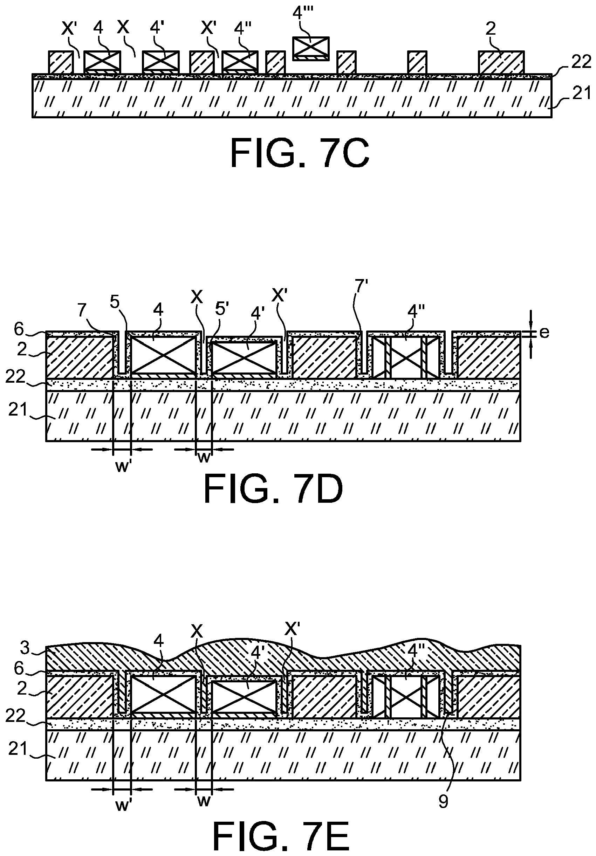

On procède ensuite au placement des composants 4 dans les cavités 7 (figure 7C), les composants 4 peuvent être du même type que ceux présentés dans le procédé décrit précédemment. La matrice d'accueil **2** pourra, à cet effet, être positionnée sur un substrat support 21 rigide et plan, qui est par exemple une autre plaquette, en silicium ou en verre ou un masque en quartz ou une plaque d'alumine. Avantageusement, le substrat support a également un CTE proche ou même identique à celui de la matrice d'accueil 2 et des composants 4 afin d'assurer un bon positionnement des composants en limitant les déplacements et/ou les contraintes au moment du durcissement du matériau d'enrobage 3 (réalisé par exemple par chauffage autour de 200°C).

La tenue temporaire des composants et de la matrice d'accueil sur le support 21 pourra se faire grâce à une couche adhérente 22 déposée sur le support (figure 7C). Cette couche 22 est choisie de la même façon que dans le premier procédé décrit précédemment.

On positionne ensuite les composants avec leur face active 10 tournée vers le support 21 ou vers l'éventuelle couche d'adhérence 22 formée sur le support 21. L'alignement dans les cavités peut être réalisé grâce à des mires qui auront été réalisées au préalable, soit sur la matrice d'accueil **2,** soit sur le substrat support 21 ou sur la couche adhérente 22. En variante il est possible de disposer d'abord les composants sur le support 21 (ou sur la couche adhérente 22) et, ensuite, de rapporter la matrice d'accueil 2 autour des composants positionnés.

Il reste des espaces X et X' entre deux composants ou entre un composant et les flancs de la cavité qui l'entoure.

Une couche tampon 6 est ensuite déposée avec une grande conformité (figure 7D). Cette couche tampon 6 recouvre la face arrière et les cotés 5 des composants, la face arrière 11' de la plaquette, les flancs des cavités 7 et le substrat 21 (ou l'éventuelle couche adhérente 22). Cette couche tampon 6 est choisie de façon à répondre aux mêmes critères que ceux cités précédemment et elle est déposée par les mêmes moyens.

L'épaisseur e de cette couche tampon est choisie de telle sorte qu'elle ne remplisse pas intégralement les cavités X et X'. Cette épaisseur est avantageusement inférieure à 0,1 fois (au moins 10 fois plus petite que) w', w' désignant la largeur de l'espace X', w' est du même ordre de grandeur que w, largeur de l'espace X.

On procède ensuite, dans chaque cavité 7, au remplissage de l'espace libre par le matériau d'enrobage 3 (figure 7E), le matériau 3 n'étant en contact direct qu'avec la couche tampon 6. Ce matériau est par exemple dispensé localement à la seringue ou bien, de façon plus grossière, en déposant une ou des grosses gouttes sur la plaquette. La pénétration de la résine d'enrobage dans entre deux composants et dans les cavités 7 pourra être facilitée par une mise sous vide. Ce matériau de remplissage 3 est ensuite durci (par exemple par chauffage).

On peut ensuite procéder à des étapes de polissage face arrière et/ou de retrait du substrat support et/ou d'ajout d'un substrat de renfort (figure 7F) comme dans le mode de réalisation précédent.

La figure 7F illustre la possibilité d'effectuer un retrait de la couche tampon présente sur la face avant du dispositif pendant ou après l'étape de retrait du substrat support. De cette façon, le matériau d'enrobage 3 est mis à jour, le matériau de la couche tampon est toujours présent de façon à permettre une séparation entre le matériau d'enrobage 3 et les flancs des cavités 7 et des composants 4. Enfin, le matériau 3 et la couche tampon 6 présentent alors une marche d'épaisseur e par rapport à la face 11 de la matrice d'accueil et aux faces 10 du ou des composants 4.

Ensuite la plaquette peut être réintroduite dans une ligne de type microélectronique pour les étapes «Above IC», par exemple du type déjà décrit ci-dessus.

Par rapport au procédé précédent, l'ajout d'une matrice d'accueil a l'avantage de présenter autour des composants 4 une surface sur laquelle une intégration de composants microélectroniques et/ou MEMS/NEMS peut déjà avoir été effectuée. Ainsi ce procédé réalisant l'invention permet non seulement de créer un dispositif multi-composant mais de créer des dispositifs de type « system in chip » dans lequel le ou les composants peuvent subir une intégration de type « above -IC » simultanée avec l'intégration des composants présents initialement sur la matrice d'accueil, évitant ainsi une surépaisseur de connections.

Comme le présente les figures 7C à 7F, il est possible d'avoir plusieurs composants intégrés dans une même cavité de la matrice d'accueil 2.

Le procédé illustré par les figures 5A à 5F peut servir à intégrer plus de deux composants et ce procédé n'utilise pas de matrice d'accueil autour des composants, la plaquette reconstituée étant composée du ou des composants discrets intégrés, de la couche tampon présente au moins latéralement par rapport à ces composants et d'une matrice composée au moins par le matériau d'enrobage 3.

Par rapport aux technologies d'assemblage conventionnelles de composants dans une plaquette (technique dite « Chip In Wafer »), les procédés selon l'invention, grâce aux propriétés physique de la couche tampon, permettent de minimiser les contraintes dans le matériau de remplissage qui peuvent courber les plaquettes. De plus, ces procédés facilitent l'industrialisation du procédé en éliminant les risques de miscibilité ou de mauvaise mouillabilité entre le matériau d'enrobage 3 et la couche d'adhérence.

Enfin, un procédé selon l'invention permet de mixer des composants 4 déjà testés (« Known Good Die »), de sources et d'épaisseurs différentes dans une même matrice 2. Il est par exemple possible d'intégrer des composants servant uniquement de passage conducteur entre les deux faces de la matrice.

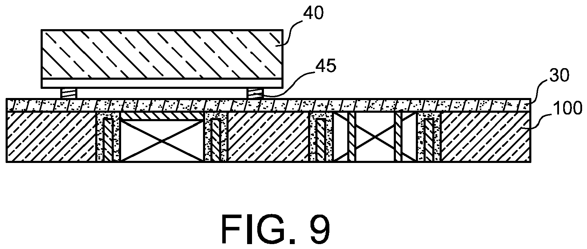

La figure 9 illustre un cas d'utilisation d'un dispositif 100 selon l'invention. Selon ce dispositif, il y a eu ajout d'une couche 30 déposée par procédé de type « above IC », cette couche mince pouvant être composée de lignes de redistribution des contacts électriques, de composants passifs de type Résistance, Inductance, Capacité, de filtres, de guides d'onde optiques... etc.

Par-dessus cette couche 30 à été déposé au moins un composant électronique 40 pouvant être du même type que les composants insérés dans la plaquette reconstituée. Ce ou ces composants supérieurs 40 sont fixés au moyen d'éléments de connexion de type billes fusibles 45, Micro inserts, stud-bump, polymère conducteurs etc....

## Revendications

1. Plaquette électronique, ayant une face avant (8) et une face arrière (8'), muni d'une pluralité de composants discrets intégrés (4, 4'), la face active (10) de chaque composant apparaissant du coté de la face avant (8) de la plaquette, comportant :
a) un matériau d'enrobage (3), présent au moins latéralement par rapport aux composants, assurant le maintient desdits composant dans la plaquette,
b) une couche tampon (6) isolante, absente de la face active (10) des composants, séparant le matériau d'enrobage (3) des composants (4, 4'), de sorte que chaque composant est séparé d'un autre composant par au moins un matériau d'enrobage intercalé entre 2 couches tampons,
caracérisée en ce que la couche tampon a une température de transisiton vitreuse inférieure à celle du matériau d'enrobage.

2. Plaquette selon la revendication 1, le matériau d'enrobage (3) étant de type époxy ou polyuréthane ou élastomère ou silicone ou acrylique ou méthacrylate ou polypropylène ou verre fusible ou de type verre fusible mélangé avec des particules, par exemple en silice, ou d'un autre type de matériau dans le but de conférer au matériau ainsi formé des propriétés électriques et/ou thermiques et/ou mécaniques.

3. Plaquette selon les revendications 1 ou 2, la couche tampon (6) étant en PMDA-DAH ou en PMDA EAD ou en PMDA ODA ou en PMDA DNB ou en PMDA-PDA, ou en poly-V3D3, ou en une résine minérale organique ou en parylène C ou en parylène N ou en parylène D,
où :
- le PMDA est le 1,2,3,5-benzenetétracarboxylic anhydride, le DNB le 2,4-diaminonitrobenzène, le ODA le 4,4-oxydianiline et le EDA l'ethylènediamine, le DAH le 1,6-diaminohéxane, et le PDA est le 1,4-phenylenediamine.
- poly-V3D3 est le poly(1,3,5-trivinyltrimethylcyclotrisiloxane).

4. Plaquette selon l'une des revendications 1 à 3, la couche tampon (6) ne remplissant pas entièrement l'espace entre les composants, l'espace restant entre les composants étant occupé par le matériau d'enrobage (3).

5. Plaquette selon l'une des revendications 1 à 4 dans lequel :
- les composants sont placés dans au moins une cavité (7) présente dans une matrice d'accueil (2) et traversant cette matrice d'accueil,
- la couche tampon (6) est au moins présente sur les flancs de la ou des cavités, séparant le matériau d'enrobage (3) du matériau de la matrice d'accueil, la couche tampon étant absente de la face avant de la matrice d'accueil (11), ladite couche tampon ne remplissant pas entièrement l'espace (X') entre les flancs de la ou des cavités et les flancs des composants, l'espace restant étant occupé par le matériau d'enrobage.

6. Plaquette selon l'une des revendications 1 à 5, la face arrière (8') de la plaquette étant fixée à un substrat de renfort (80) pour assurer la rigidité mécanique.

7. Plaquette selon l'une des revendications 1 à 6 dans lequel la couche tampon (6) masque le matériau d'enrobage (3) sur la face avant (8) de la plaquette.

8. Plaquette selon l'une des revendications 1 à 7, le matériau d'enrobage (3) étant apparent sur la face avant (8) du dispositif, la couche tampon (6) n'étant présente que sur les flancs (5) des composants (4), le matériau d'enrobage et la couche tampon présentant un retrait (e) par rapport à la surface active des composants (10).

9. Procédé d'intégration d'au moins un composant discret (4) dans une plaquette, dite plaquette reconstituée, dans lequel :
a) on positionne au moins un composant discret sur un substrat (21), dit substrat support,
b) on dépose une couche tampon (6) au moins sur la face arrière et le s flancs (5) du composant, ladite couche tampon ne se déposant pas sur les surfaces du composant en contact avec le substrat,
c) on dépose un matériau d'enrobage (3) au moins latéralement par rapport au composant, ce matériau étant déposé sur des surfaces recouvertes par la couche tampon.

10. Procédé selon la revendication 9, dans lequel une couche adhérente (22) est déposée sur le substrat support (21) préalablement à l'étape a), la couche tampon (6) déposée en b) étant déposée sur au moins une partie du matériau adhérent non occupé par un composant (4), et sur la face arrière et les flancs (5) du composant.

11. Procédé selon la revendication 10, la couche tampon (6) étant non-miscible avec la couche d'adhérence (22).

12. Procédé selon l'une des revendications 10 à 11, la couche tampon adhérant (6) sur la face arrière et les flancs (5) du ou des composant(s) (4).

13. Procédé selon l'une des revendications 9 à 12, dans lequel on positionne plusieurs composants, la couche tampon (6) déposée à l'étape b) ne remplissant pas entièrement l'espace entre les composants (4), l'espace (X) restant étant occupé par le matériau d'enrobage (3).

14. Procédé selon l'une des revendications 9 à 13 dans lequel :
- l'étape a) comporte le positionnement de un ou plusieurs composant (4) dans une ou plusieurs cavités (7) traversant une matrice d'accueil (2),
- et l'étape b) comporte la formation de la couche tampon (6) au moins sur la face arrière de la matrice et les flancs de la ou des cavités, sans remplir entièrement l'espace (X') entre le flanc des cavités et le flanc des composants, et sépare, à l'issue de l'étape c), le matériau d'enrobage (3) du matériau de la matrice d'accueil.

15. Procédé selon l'une des revendications 9 à 14, comportant en outre une étape de retrait du substrat support (21) et de l'éventuelle couche adhésive (22) selon leur nature, par pelage, ou par gravure chimique ou par insolation ou par polissage, laissant apparaître une face, dite face avant (8), de la plaquette reconstituée, ce procédé comportant évnetuellement en outre une étape de retrait d'au moins une partie de la couche tampon (6) présente sur la face avant (8) de la plaquette reconstituée, le matériau d'enrobage (3) étant mis à nu et présentant un retrait (e) par rapport aux faces actives (10) du ou des composants (4), la couche tampon étant toujours présente sur au moins une partie des flancs (5) du ou des composant(s).

## Patentansprüche

1. Elektronische Platine mit einer Vorderseite (8) und einer Rückseite (8') und mit einer Mehrzahl von integrierten diskreten Komponenten (4, 4'), wobei die aktive Seite (10) jeder Komponente auf der Seite der Vorderseite (8) der Platine erscheint, enthaltend:
a) ein Beschichtungsmaterial (3), das zumindest seitlich in Bezug auf die Komponenten vorhanden ist und den Halt der Komponenten in der Platine gewährleistet,
b) eine isolierende Pufferschicht (6), die auf der aktiven Seite (10) der Komponenten fehlt und das Beschichtungsmaterial (3) von den Komponenten (4, 4') trennt, derart, dass jede Komponente durch zumindest ein zwischen zwei Pufferschichten eingefügtes Beschichtungsmaterial von einer anderen Komponente getrennt ist,
**dadurch gekennzeichnet, dass**
die Pufferschicht eine Glasübergangstemperatur aufweist, die niedriger als die des Beschichtungsmaterials ist.

2. Platine nach Anspruch 1, wobei das Beschichtungsmaterial (3) vom Typ Epoxid oder Polyurethan oder Elastomer oder Silikon oder Acryl oder Methacrylat oder Polypropylen oder Schmelzglas oder vom Typ Schmelzglas vermischt mit Partikeln, beispielsweise Siliciumdioxid, oder von einem anderen Materialtyp ist, zu dem Zweck, dem so gebildeten Material elektrische und/oder thermische und/oder mechanische Eigenschaften zu verleihen.

3. Platine nach Anspruch 1 oder 2, wobei die Pufferschicht (6) aus PMDA-DAH oder aus PMDA EAD oder aus PMDA ODA oder aus PMDA DNB oder aus PMDA-PDA oder aus Poly-V3D3 oder aus einem organischen Mineralharz oder aus Parylen C oder aus Parylen N oder aus Parylen D besteht,
worin
- PMDA 1,2,3,5-Benzoltetracarboxylic-Anhydrid ist, DNB 2,4-Diaminonitrobenzol ist, ODA 4,4-Oxydianilin ist und EDA Ethylendiamin ist, DAH 1,6-Diaminohexan ist und PDA 1,4-Phenylendiamin ist,
- Poly-V3D3 Poly(1,3,5-Trivinyltrimethylcyclotrisiloxan) ist.

4. Platine nach einem der Ansprüche 1 bis 3, wobei bei einer den Raum zwischen den Komponenten nicht vollständig ausfüllenden Pufferschicht (6) der verbleibende Raum zwischen den Komponenten von dem Beschichtungsmaterial (3) eingenommen wird.

5. Platine nach einem der Ansprüche 1 bis 4, wobei:
- die Komponenten in zumindest einem Hohlraum (7) angeordnet sind, der in einer Aufnahmematrix (2) vorhanden ist und diese Aufnahmematrix durchquert,
- die Pufferschicht (6) zumindest an den Flanken des bzw. der Hohlräume vorhanden ist und das Beschichtungsmaterial (3) von dem Material der Aufnahmematrix trennt, wobei die Pufferschicht an der Vorderseite der Aufnahmematrix (11) fehlt, wobei die Pufferschicht den Raum (X') zwischen den Flanken des bzw. der Hohlräume und den Flanken der Komponenten nicht vollständig ausfüllt, wobei der verbleibende Raum von dem Beschichtungsmaterial eingenommen wird.

6. Platine nach einem der Ansprüche 1 bis 5, wobei die Rückseite (8') der Platine an ein Verstärkungssubstrat (80) befestigt ist, um die mechanische Steifigkeit sicherzustellen.

7. Platine nach einem der Ansprüche 1 bis 6, wobei die Pufferschicht (6) das Beschichtungsmaterial (3) an der Vorderseite (8) der Platine verdeckt.

8. Platine nach einem der Ansprüche 1 bis 7, wobei das Beschichtungsmaterial (3) an der Vorderseite (8) der Vorrichtung erscheint, die Pufferschicht (6) nur an den Flanken (5) der Komponenten (4) vorhanden ist und das Beschichtungsmaterial und die Pufferschicht einen Rücksprung (e) bezüglich der aktiven Fläche der Komponenten (10) aufweisen.

9. Verfahren zum Integrieren zumindest einer diskreten Komponente (4) in eine Platine, rekonstituierte Platine genannt, wobei:
a) zumindest eine diskrete Komponente auf ein Substrat (21), Trägersubstrat genannt, positioniert wird,
b) eine Pufferschicht (6) zumindest auf die Rückseite und auf die Flanken (5) der Komponente aufgebracht wird, wobei die Pufferschicht nicht auf die Flächen der Komponente in Kontakt mit dem Substrat aufgebracht wird,
c) ein Beschichtungsmaterial (3) zumindest seitlich in Bezug auf die Komponente aufgebracht wird, wobei dieses Material auf die von der Pufferschicht überdeckten Flächen aufgebracht wird.

10. Verfahren nach Anspruch 9, wobei vor dem Schritt a) eine Haftschicht (22) auf das Trägersubstrat (21) aufgebracht wird, wobei die in b) aufgebrachte Pufferschicht (6) auf zumindest einen Teil des Haftmaterials aufgebracht wird, der nicht von einer Komponente (4) eingenommen wird, sowie auf die Rückseite und auf die Flanken (5) der Komponente.

11. Verfahren nach Anspruch 10, wobei die Pufferschicht (6) nicht mit der Haftschicht (22) mischbar ist.

12. Verfahren nach einem der Ansprüche 10 bis 11, wobei die Pufferschicht (6) an der Rückseite und an den Flanken (5) der Komponente bzw. Komponenten (4) anhaftet.

13. Verfahren nach einem der Ansprüche 9 bis 12, wobei mehrere Komponenten positioniert werden, wobei die in Schritt b) aufgebrachte Pufferschicht nicht vollständig den Raum zwischen den Komponenten (4) ausfüllt, wobei der verbleibende Raum (X) von dem Beschichtungsmaterial (3) eingenommen wird.

14. Verfahren nach einem der Ansprüche 9 bis 13, wobei:
- der Schritt a) das Positionieren von einer oder mehreren Komponenten (4) in einem oder mehreren Hohlräumen (7) umfasst, die eine Aufnahmematrix (2) durchqueren,
- und der Schritt b) das Bilden der Pufferschicht (6) zumindest an der Rückseite der Matrix und an den Flanken des bzw. der Hohlräume umfasst, ohne dabei den Raum (X') zwischen der Flanke der Hohlräume und der Flanke der Komponenten vollständig auszufüllen, und am Ende von Schritt c) das Beschichtungsmaterial (3) vom Material der Aufnahmematrix trennt.

15. Verfahren nach einem der Ansprüche 9 bis 14, ferner umfassend einen Schritt des Entfernens des Trägersubstrats (21) und der gegebenenfalls vorgesehenen Haftschicht (22) je nach Beschaffenheit durch Abziehen oder durch chemisches Ätzen oder durch Insolation oder durch Polieren, wobei eine Seite, Vorderseite (8) genannt, der rekonstituierten Platine freigelegt wird, wobei dieses Verfahren gegebenenfalls ferner einen Schritt des Entfernens zumindest eines Teils der Pufferschicht (6) umfasst, die an der Vorderseite (8) der rekonstituierten Platine vorhanden ist, wobei das Beschichtungsmaterial (3) freigelegt wird und einen Rücksprung (e) bezüglich der aktiven Flächen (10) der Komponente bzw. Komponenten (4) aufweist, wobei die Pufferschicht immer noch auf zumindest einem Teil der Flanken (5) der Komponente bzw. Komponenten vorhanden ist.

## Claims

1. Electronic wafer, having a front face (8) and a rear face (8'), fitted with a plurality of discrete integrated components (4, 4'), the active face (10) of each component appearing to the side of the front face (8) of the wafer, comprising:
a) a coating material (3), present at least laterally relative to the components, ensuring that said component is held in the wafer,
b) an insulating buffer layer (6) absent from the active face (10) of the components, separating the coating material (3) from the components (4, 4'), so that each component is separated from another component by at least one coating material interposed between 2 buffer layers,
**characterised in that** the buffer layer has a vitreous transition temperature less than that of the coating material.

2. Wafer according to claim 1, the coating material (3) being of epoxy or polyurethane or elastomer or silicone or acrylic or methacrylate or polypropylene or glass fusible type or of glass fusible type mixed with particles, for example made of silica, or some other type of material with the aim of imparting electric and/or thermal and/or mechanical properties to the thus formed material.

3. Wafer according to claim 1 or 2, the buffer layer (6) being made of PMDA-DAH or PMDA EAD or PMDA ODA, or poly-V3D3, or an organic mineral resin or parylene C or parylene N or parylene D,
Wherein:
PMDA is the 1,2,3,5-benzene tetracarboxylic anhydride, DNB is 2,4-diaminonitrobenzene, ODA is 4,4 - oxydianiline and EDA is ethylenediamine, DAH is 1,6-diaminohexane, PDA is 1,4-phenylenediamine,
poly-V3D3 is poly(1,3,5-trivinyltrimethylcyclotrisiloxane).

4. Wafer according to any of claims 1 to 4, the buffer layer (6) not entirely filling the space between the components, the space remaining between the components being occupied by the coating material (3).

5. Wafer according to any of claims 1 to 4, in which:
- the components are placed in at least one cavity (7) present in a receiving matrix (2) and passing through this receiving matrix,
- the buffer layer (6) is at least present on the flanks of the cavity or cavities, separating the coating material (3) from the material of the receiving matrix, the buffer layer being absent from the front face of the receiving matrix (11), said buffer layer not entirely filling the space (X') between the flanks of the cavity or cavities and the flanks of the components, the space remaining being occupied by the coating material.

6. Wafer according to any of claims 1 to 5, the rear face (8') of the wafer being fixed to a reinforcing substrate (80) to ensure mechanical rigidity.

7. Wafer according to any of claims 1 to 6, in which the buffer layer (6) masks the coating material (3) on the front face (8) of the wafer.

8. Wafer according to any of claims to 7, the coating material (3) being visible on the front face (8) of the device, the buffer layer (6) being present only on the flanks (5) of the components (4), the coating material and the buffer layer laying back relative to the active surface of the components (10).

9. Process for integration of at least one discrete component (4) in a wafer, said reconstituted wafer, in which:
a) at least one discrete component is positioned on a substrate (21), said support substrate,
b) a buffer layer (6) is deposited at least on the rear face and the flanks (5) of the component, said buffer layer not being deposited on the surfaces of the component in contact with the substrate,
c) coating material (3) is deposited at least laterally relative to the component, this material being deposited on surfaces covered by the buffer layer.

10. Process according to claim 9, in which an adhesive layer (22) is deposited on the support substrate (21) prior to step a), the buffer layer (6) deposited in b) being deposited on at least part of the adhesive material not occupied by a component (4), and on the rear face and the flanks (5) of the component.

11. Process according to claim 10, the buffer layer (6) being immiscible with the adhesion layer (22).

12. Process according to any of claims 10 to 11, the buffer layer (6) adhering on the rear face and the flanks (5) of the component(s) (4).

13. Process according to any of claims 9 to 12, in which several components are positioned, the buffer layer (6) deposited at step b) not entirely filling the space between the components (4), the remaining space (X) being occupied by the coating material (3).

14. Process according to any of claims 9 to 13 in which:
- step a) comprises positioning one or more components (4) in one or more cavities (7) passing through a receiving matrix (2),
- and step b) comprises formation of the buffer layer (6) at least on the rear face of the matrix and the flanks of the cavity or cavities, without entirely filling the space (X') between the flank of the cavities and the flank of the components, and separates, on completion of step c), the coating material (3) from the material of the receiving matrix.

15. Process according to any of claims 9 to 14, further comprising a removal step of the support substrate (21) and of the optional adhesive layer (22) according to their nature, by peeling, or by chemical etching or by insolation or by polishing, exposing a face, said front face (8), of the reconstituted wafer, this process possibly comprising a removal step of at least part of the buffer layer (6) present on the front face (8) of the reconstituted wafer, the coating material (3) being laid bare and laying back relative to the active faces (10) of the component or components (4), the buffer layer still being on at least part of the flanks (5) of the component(s).
